# EUROPÄISCHE PATENTSCHRIFT

(11) **EP 1 699 967 B1**
(45) Veröffentlichungstag und Bekanntmachung des Hinweises auf die Patenterteilung: **04.03.2015**
(21) Anmeldenummer: 04804764.1
(22) Anmeldetag: 10.12.2004
(51) Int. Cl.: A47L 15/42, A47L 15/46, D06F 33/02, D06F 39/08, H05K 3/30

(54) **ELEKTRISCHE SCHNITTSTELLE FÜR WASSERFÜRENDE HAUSHALTSGERÄTE**
ELECTRIC INTERFACE FOR WATER-BEARING HOUSEHOLD DEVICES
INTERFACE ELECTRIQUE CONCUE POUR DES APPAREILS MENAGERS CONDUISANT DE L'EAU

(30) Priorität: 22.12.2003 DE 10360559; 21.04.2004 DE 102004019343
(43) Veröffentlichungstag der Anmeldung: 13.09.2006
(73) Patentinhaber: BSH Bosch und Siemens Hausgeräte GmbH, 81739 München (DE)
(72) Erfinder: ROSENBAUER, Michael, 86756 Reimlingen (DE); STICKEL, Martin, 89537 Giengen (DE)
(86) Internationale Anmeldenummer: PCT/EP2004/053395
(87) Internationale Veröffentlichungsnummer: WO 2005/061776

(56) Entgegenhaltungen:
- EP-A- 0 585 692
- EP-A- 0 860 535
- DE-A1- 2 614 053
- PATENT ABSTRACTS OF JAPAN Bd. 1996, Nr. 03, 29. März 1996 (1996-03-29) -& JP 07 289782 A (TOSHIBA CORP; others: 01), 7. November 1995 (1995-11-07)

## Beschreibung

Gegenstand der vorliegenden Erfindung ist eine elektrische Schnittstelle für wasserführende Haushaltsgeräte, wie z.B. Geschirrspülmaschinen oder Waschmaschinen. Die vorliegende Erfindung betrifft insbesondere eine elektrische Schnittstelle zur ökonomischen Anordnung hydraulischer, mechanischer und elektronischer Komponenten, die für die Betriebssteuerung des wasserführenden Haushaltsgeräts erforderlich sind.

Es ist bekannt, bei wasserführenden Haushaltsgeräten elektrisch ansteuerbare Magnetventile zur Regelung von hydraulischen Kreisläufen, wie z.B. dem Wasch- bzw. Spülflüssigkeitskreislauf, einzusetzen. Dabei sind die Magnetventile häufig direkt mit den zu steuernden Hydraulikkreisläufen verbunden, indem sie in den wasserführenden Bauteilen eingebaut werden. Üblicherweise werden die Magnetventile von einer Betriebs- bzw. Programmsteuerung des wasserführenden Haushaltsgeräts über mechanische oder elektronische Steuerelemente gesteuert.

Es ferner bekannt, in den Geschirrspülmaschine Sensoren zu verwenden, die der Erfassung von hydraulischen und spülergebnisrelevanten Parametern dienen. Über einen zusätzlich notwendigen Kabelbaum und Steckkontakte werden die Magnetventile und Sensoren mit der in der Geschirrspülmaschine meist an einem anderen Ort liegenden Programmsteuerung verbunden, um die Magnetventile und Sensoren dem Betriebsablauf entsprechend anzusteuern. Die bekannten Betriebssteuerungen haben den Nachteil, dass jedes Magnetventil und jeder Sensor separat mit der Programmsteuerung verbunden werden muss. Da die Positionierung der Magnetventile und Sensoren in den hydraulischen Kreisläufen von den hydraulischen oder bauteilspezifischen Gegebenheiten des wasserführenden Haushaltsgeräts abhängig ist, ist die Kontaktierung der elektronischen, hydraulischen und mechanischen Komponenten der Betriebssteuerung über einen weit verzweigten Kabelbaum erforderlich. Dadurch ist ein flexibler und modularer Aufbau der für die Betriebssteuerung erforderlichen Komponenten unmöglich.

Eine elektrische Schnittstelle mit allen Merkmalen des Oberbegriffs des unabhängigen Anspruchs 1 ist beispielsweise aus EP 0 860 535 A2 bekannt

Aufgabe der Erfindung ist es, unter ökonomischen Aspekten eine elektrische Schnittstelle für wasserführende Haushaltsgeräte zu schaffen, die eine flexible und modulare Anordnung der für die Betriebssteuerung des wasserführenden Haushaltsgeräts erforderlichen hydraulischen und elektronischen Komponenten ermöglicht.

Diese Aufgabe wird durch die erfindungsgemäße Geschirrspülmaschine mit den Merkmalen gemäß Anspruch 1 gelöst. Vorteilhafte Weiterbildungen der vorliegenden Erfindung sind in den Unteransprüchen 2 bis 10 gekennzeichnet.

Die vorliegende Erfindung schafft eine elektrische Schnittstelle für wasserführende Haushaltsgeräte mit einer Programmsteuerung und mit elektronischen Komponenten zur Ansteuerung mindestens eines Magnetventils zur Regelung einer Flüssigkeitsleitung, wobei zumindest ein Teil der elektronischen Komponenten und das Magnetventil in einer Bauteilgruppe integriert sind, die mit der Programmsteuerung verbunden ist.

Durch die Integration von hydraulischen Magnetventilen zusammen mit zur Steuerung der Magnetventile erforderlichen elektronischen Komponenten in einer Bauteilgruppe, die mit der Programmsteuerung des wasserführenden Haushaltsgeräts verbunden ist, wird der Vorteil erreicht, dass die notwendigen elektrischen Verbindungen zwischen der Programmsteuerung, den einzelnen Magnetventilen und den elektronischen Komponenten für die Ansteuerung der Magnetventile reduziert werden. Mit der erfindungsgemäßen Schnittstelle wird eine Integration von Magnetventilen bzw. Stellgliedern und damit eine modulare Schnittstelle zwischen dem hydraulischen und dem elektronischem Bereich in einer Bauteilgruppe erreicht. Dadurch wird einerseits die Komplexität des Kabelbaums zur elektrischen Verbindung der hydraulischen und der elektronischen Bauteile verringert und ein andererseits ein modularer Aufbau der betreffenden Komponenten ermöglicht.

Bei einer bevorzugten Ausführungsform der vorliegenden Erfindung ist in der Bauteilgruppe zusätzlich mindestens ein Sensor integriert, der für die Regelung der Flüssigkeitsleitung relevante Parameter erfasst und an die vorzugsweise elektronische Programmsteuerung weiterleitet. Dabei sind insbesondere hydraulische Parameter, wie z.B. die Menge der in der Flüssigkeitsleitung beförderten Flüssigkeit, für die Programmsteuerung von Bedeutung. Aufgrund der Integration der Sensoren in der Bauteilgruppe, können die von den Sensoren ermittelten hydraulischen Parameter auch direkt an die in derselben Bauteilguppe untergebrachten elektronischen Komponenten zur Steuerung der Magnetventile übermittelt werden.

Die durch Magnetventile geregelte Flüssigkeitsleitung kann beispielsweise die Frischwasserzufuhr einer wasserführenden Haushaltsmaschine, der Waschflüssigkeitskreislauf einer Waschmaschine oder der Spülflüssigkeitskreislauf einer Geschirrspülmaschine sein. Besonders vorteilhaft ist es, wenn in der Bauteilgruppe eine Anzahl von Magnetventilen zur Regelung mehrerer Flüssigkeitsleitungen, wie z.B. der Frischwasserzufuhr und der Wasch- bzw. Spülflüssigkeitsleitung, integriert ist. Durch die Integration von Magnetventilen, elektronischen Komponenten und Sensoren in einer Bauteilgruppe wird der modulare Aufbau der betreffenden Komponenten weiter verbessert, da diese in einer Bauteilgruppe vormontiert und als eine Einheit in der wasserführenden Haushaltsmaschine eingesetzt werden kann.

Zweckmäßigerweise umfassen die elektronischen Komponenten zur Ansteuerung der Magnetventile mindestens einen Mikroprozessor, der beispielsweise in der Lage ist, die von den Sensoren bezüglich der hydraulischen Parameter gelieferten Messwerte zu verarbeiten und in Übereinstimmung mit der Programmsteuerung der Haushaltsmaschine die erforderlichen Steuersignale für die Magnetventile zu berechnen. Um die Verbindung der Bauteilgruppe mit der Programmsteuerung des wasserführenden Haushaltsgeräts herzustellen, ist an der Bauteilgruppe vorzugsweise mindestens ein elektrischer Anschluss vorgesehen, der vorzugsweise als Gruppenstecker mit einer Anzahl von elektrischen Kontakten ausgebildet ist. Auf diese Weise kann die elektrische Verbindung zwischen der Bauteilgruppe und der Programmsteuerung mit nur einem Stecker bewerkstelligt werden, was die Montage oder den Austausch der Bauteilgruppe erleichtert.

Bei der vorliegenden Erfindung ist die elektrische Schnittstelle als Steckplatine ausgebildet, die mit einem elektrischen Anschluss in einen dafür vorgesehenen komplementär ausgebildeten Steckplatz in der Haushaltsmaschine eingesteckt werden kann. Dazu ist vorzugsweise ein Abschnitt am Rand der Platine als elektrischer Anschluss mit einer Anzahl von elektrischen Kontakten ausgebildet. Mit diesem Abschnitt am Rand der Platine kann die Bauteilgruppe bei der Montage in einen dafür vorgesehenen komplementär ausgebildeten Steckplatz in der Geschirrspülmaschine auf schnelle und einfache Weise eingesetzt werden.

Der modulare Aufbau der wasserführenden Haushaltsmaschine wird besonders begünstigt, wenn die Magnetventile, die elektronischen Komponenten und vorzugsweise auch die Sensoren der elektrischen Schnittstelle auf der Platine angeordnet sind. Dadurch können je nach Bauart der wasserführenden Haushaltsmaschine die erforderlichen hydraulischen, sensorischen und elektronischen Komponenten in einer Bauteilgruppe vormontiert und in die Haushaltsmaschine eingesetzt werden.

Besonders vorteilhaft ist es, wenn die Magnetventile und/oder die Sensoren auf e iner oder mehreren Steckleisten angeordnet sind, die mit der Platine über elektrische Leitungen verbunden sind. Eine solche Steckleiste ermöglicht die genaue Anordnung eines oder mehrerer Magnetventile bzw. Sensoren sowie die Kontaktierung derselben. Je nach Bedarf kann die erfindungsgemäße Schnittstelle durch einfache Steckanordnung mit mehr oder weniger Magnetventilen oder Sensoren ausgestattet werden. Dazu ist die Steckleiste für die Magnetventile und/oder die Sensoren mit einer Anzahl von Steckplätzen ausgestattet, die zur elektrischen Kontaktierung der Magnetventile und/oder der Sensoren dienen.

Bei einer weiteren bevorzugten Ausführungsform der vorliegenden Erfindung ist die Steckleiste auf der Platine der elektrischen Schnittstelle angeordnet, die auch die elektronischen Bauteile zur Ansteuerung der Magnetventile und Sensoren trägt, so dass ein in sich geschlossenes Steuer- und Regelmodul entsteht, das vorzugsweise mit einem einzigen Stecker direkt an ein Steuerungsmodul oder direkt an die Programmsteuerung der Haushaltsmaschine angeschlossen werden kann. Je nach Bauart und Ausführung der Haushaltsmaschine kann die Bauteilgruppe der erfindungsgemäßen Schnittstelle in seiner Ausstattung durch eine entsprechende Bestückung der Steckleisten variert werden. Um eine zuverlässige Anordnung der Magnetventile und der Sensoren auf der Steckleiste zu gewährleisten, können die Steckplätze zusätzlich Mittel zur mechanischen Verrastung der Magnetventile und/oder der Sensoren bzw. für deren elektrische Anschlüsse aufweisen.

Im Folgenden wird die vorliegende Erfindung unter Bezugnahme auf die beigefügten Zeichnungen anhand eines bevorzugten Ausführungsbeispiels näher erläutert. Es zeigen:
Figur 1 eine perspektivische Darstellung einer elektrischen Schnittstelle gemäß einer bevorzugten Ausführungsform der vorliegenden Erfindung;
Figur 2 eine perspektivische Detailansicht der in Figur 1 dargestellten elektrischen Schnittstelle gemäß einer bevorzugten Ausführungsform der vorliegenden Erfindung;
Figur 3 eine Schnittdarstellung durch eine Steckverbindung zur Herstellung des elektrischen Kontakts zwischen der erfindungsgemäßen Schnittstelle und einem Magnetventil oder einem Sensor.

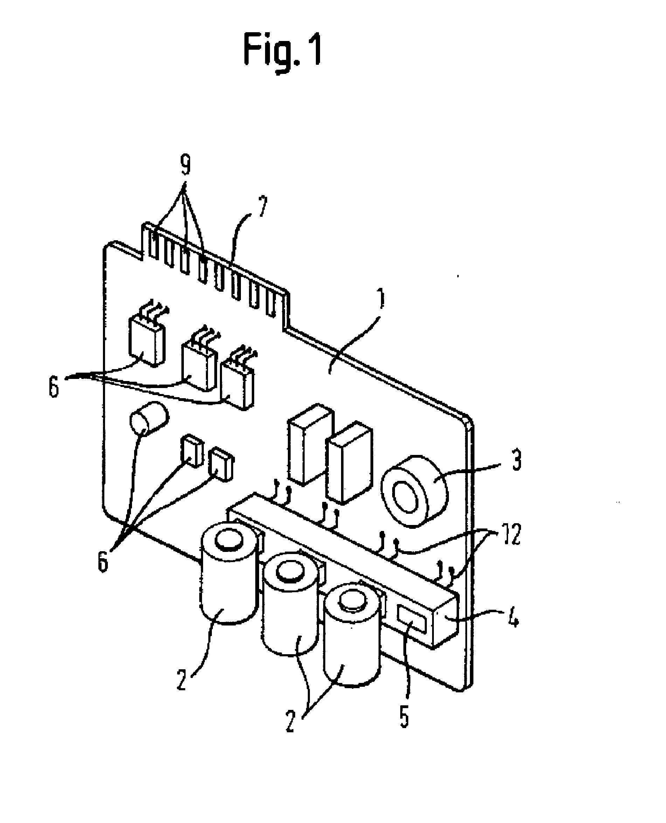

Die erfindungsgemäße elektrische Schnittstelle dient der funktionalen Verbindung zwischen hydraulischen und elektronischen Komponenten einer wasserführenden Haushaltsmaschine, die mit einer vorzugsweise elektrischen Programmsteuerung ausgestattet ist. Die elektrische Schnittstelle umfasst in der in Figur 1 dargestellten Ausführungsform eine Platine 1, auf der mehrere Magnetventile 2 zur Regelung von Flüssigkeitsleitungen (nicht dargestellt) in einer wasserführenden Haushaltsmaschine angeordnet sind. Auf der Platine 1 sind ferner elektronische Komponenten 6 zur Ansteuerung der Magnetventile 2 angeordnet. Die Magnetventile 2 können über die elektronischen Komponenten 6 von der Programmsteuerung der Haushaltsmaschine beispielsweise so angesteuert werden, dass sie die betreffende Flüssigkeitsleitung öffnen, schließen oder nur einen gedrosselten Flüssigkeitsdurchfluss ermöglichen. Durch die Magnetventile 2 können beispielsweise die Frischwasserzufuhr einer Haushaltsmaschine, der Waschflüssigkeitskreislauf einer Waschmaschine oder der Spülflüssigkeitskreislauf einer Geschirrspülmaschine geregelt werden.

Auf der Platine 1 der in Figur 1 dargestellten Schnittstelle ist auch ein Sensor 3 angeordnet, der für die Regelung der Flüssigkeitsleitung relevante Parameter, wie z.B. die Menge der in der Flüssigkeitsleitung beförderten Flüssigkeit, erfasst und ein entsprechendes Signal an die Programmsteuerung der Haushaltsmaschine weiterleitet. Aufgrund der Integration des Sensors in der Bauteilgruppe auf der Platine 1 können die vom Sensor 3 ermittelten hydraulischen Parameter auch direkt an die auf der Platine 1 angeordneten elektronischen Komponenten 6 zur Steuerung der Magnetventile 2 übermittelt werden. Auf diese Weise sind die elektronischen Komponenten 6, die Magnetventile 2 und die Sensoren 3 zu einer Bauteilgruppe integriert. Dadurch werden die notwendigen elektrischen Verbindungen zwischen der Programmsteuerung, den einzelnen Magnetventilen 2, den elektronischen Komponenten 6 für die Ansteuerung der Magnetventile und den sensorischen Komponenten 3 reduziert.

Zur Verbindung der Bauteilgruppe auf der Platine 1 mit der Programmsteuerung des wasserführenden Haushaltsgeräts ist ein Abschnitt am Rand der Platine 1 als elektrischer Anschluss 7 ausgebildet, der eine Anzahl von elektrischen Kontakten 9 aufweist. Über den elektrischen Anschluss 7 kann die elektrische Verbindung zwischen der Bauteilgruppe auf der Platine 1 und der Programmsteuerung mit nur einem Stecker bewerkstelligt werden, was die Montage oder den Austausch der Bauteilgruppe erleichtert.

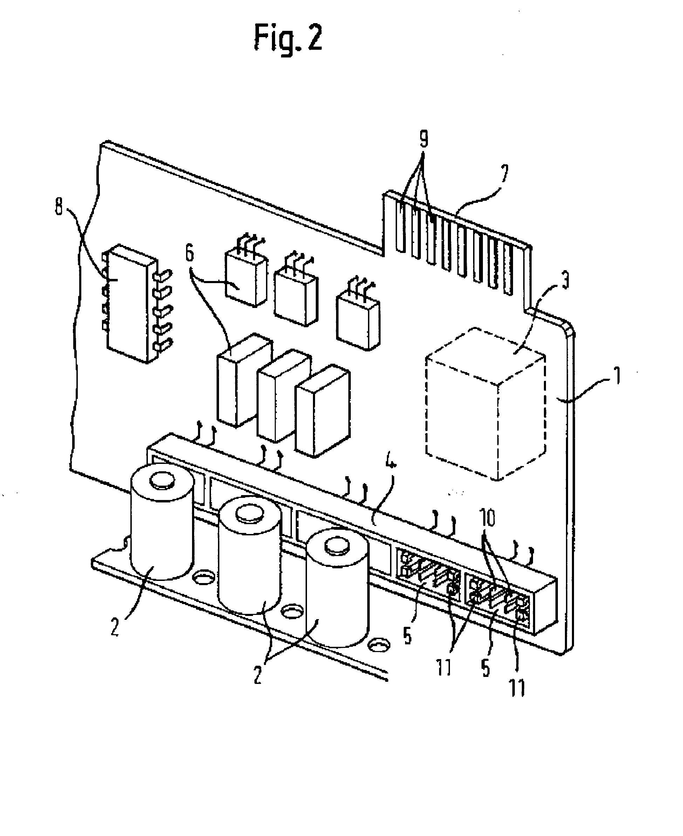

Figur 2 zeigt eine perspektivische Detailansicht der in Figur 1 dargestellten elektrischen Schnittstelle gemäß einer bevorzugten Ausführungsform der vorliegenden Erfindung. Figur 2 ist zu entnehmen, dass die elektronischen Komponenten 6 zur Ansteuerung der Magnetventile 2 mindestens einen Mikroprozessor 8 umfassen, der in der Lage ist, die vom Sensor 3 bezüglich der hydraulischen Parameter gelieferten Messwerte zu verarbeiten und in Übereinstimmung mit der Programmsteuerung der Haushaltsmaschine die erforderlichen Steuersignale für die Magnetventile 2 zu berechnen.

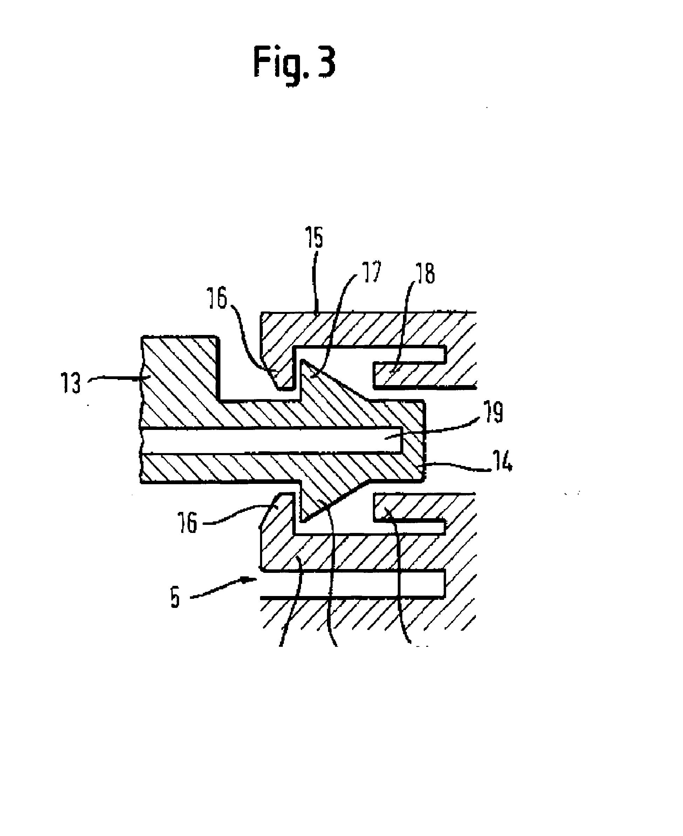

Bei der in den Figuren 1 und 2 dargestellten Ausführungsform der vorliegenden Erfindung ist die elektrische Schnittstelle als Steckplatine 1 ausgebildet ist, so dass der elektrische Anschluss 7 am Rand der Platine 1 in einen dafür vorgesehenen komplementär ausgebildeten Steckplatz in der Haushaltsmaschine eingesteckt werden kann. Die Magnetventile 2 sind auf einer Steckleiste 4 angeordnet, die mit der Platine 1 über elektrische Leitungen 12 verbunden sind. Die Steckleiste 4 weist eine Anzahl von Steckplätzen 5 auf, in denen die Magnetventile 2 bzw. deren elektrische Anschlüsse eingesteckt werden können. Dadurch können je nach Bauart der wasserführenden Haushaltsmaschine die erforderliche Anzahl von Magnetventilen 2 auf der Steckleiste 4 vormontiert und in die Haushaltsmaschine eingesetzt werden. Die Steckplätze 5 sind jeweils mit elektrischen Kontakten 10 für die elektrische Kontaktierung und mit mechanischen Rastmitteln 11 zur mechanischen Arretierung der Magnetventile 2 ausgestattet, auf die in der Beschreibung zu Figur 3 noch näher eingegangen wird. Dadurch wird eine ebenso schnelle wie einfache Bestückung der Platine 1 mit den erforderlichen Magnetventilen 2 ermöglicht sowie eine übersichtliche und zuverlässige Anordnung und Kontaktierung der Magnetventile 2 erreicht.

Durch die Anordnung der hydraulischen, sensorischen und der elektronischen Komponenten 2, 3, 6, 8 zur Ansteuerung der Magnetventile in einer Bauteilgruppe auf der Platine 1 der erfindungsgemäßen Schnittstelle wird ein in sich geschlossenes Steuer- und Regelmodul geschaffen. Je nach Bauart und Ausführung der Haushaltsmaschine kann die Bauteilgruppe der erfindungsgemäßen Schnittstelle in seiner Ausstattung durch eine entsprechende Bestückung der Platine 1 und der Steckleiste 4 variiert werden. Mit Hilfe der erfindungsgemäßen Schnittstelle wird so eine Verringerung der Komplexität des Kabelbaums zur elektrischen Verbindung der hydraulischen, sensorischen und der elektronischen Bauteile erreicht und ein modularer Aufbau der betreffenden Haushaltsmaschine begünstigt.

Die Steckleiste 4 kann auch dafür vorgesehen sein, in ihren Steckplätzen 5 ein Magnetventil 2 oder einen Sensor 3 aufzunehmen. Figur 3 zeigt eine Schnittdarstellung durch eine Steckverbindung zur Herstellung des elektrischen Kontakts zwischen der erfindungsgemäßen Schnittstelle und einem Magnetventil 2 oder einem Sensor 3. In Figur 3 ist ein Querschnitt durch einen Steckplatz 5 der Steckleiste 4 dargestellt, in den der elektrische Anschluss 13 eines Magnetventils 2 oder Sensors 3 eingesteckt ist und sich in der Einrastposition befindet. Der Steckplatz 5 weist zwei symmetrisch gegenüberliegend angeordnete Rastmittel auf, die jeweils als elastisch federnde Schnapphaken 15 ausgebildet sind, an deren freien Ende ein nach innen gerichteter Vorsprung 16 angeordnet ist. Der elektrische Anschluss des Magnetventils 2 bzw. des Sensors 3 weist symmetrisch angeordnete Flanken 17 auf, die in der Einrastposition die Vorsprünge 16 der federnden Schnapphaken 15 hintergreifen und damit eine Verrastung zwischen dem Steckplatz 5 und dem elektrischen Anschluss 13 des Magnetventils 2 bzw. des Sensors 3 herstellen.

Die Flanken 17 des elektrischen Anschluss 13 weisen auf der zur Spitze 14 gerichteten Seite eine schräg ansteigende Fläche auf, so dass die elastisch federnden Schnapphaken 15 während der Enführbewegung des elektrischen Anschluss 13 in den Steckplatz 5 nach außen gedrückt werden und in der Enrastposition hinter der Flanke 17 einschnappen. Die Spitze 14 des elektrischen Anschluss 13 wird durch Führungshilfen 18 während der Enführbewegung in die gewünschte Kontaktposition gebracht und dort in der Einrastposition gehalten. In der Mitte des elektrischen Anschluss 13 ist ein Kanal 19 ausgebildet, in dem die elektrischen Leitungen verlaufen und in der Enrastposition die elektrische Verbindung zum Steckplatz 5 und damit zu der elektrischen Schnittstelle herstellen.

### Liste der Bezugszeichen

1 Platine der Schnittstelle
2 Magnetventile
3 Sensor
4 Steckleiste für Magnetventile 2
5 Steckplatz auf der Steckleiste 4
6 elektronische Bauteile
7 elektrischer Anschluss der Platine 1
8 Mikroprozessor
9 Kontakte des elektrischen Anschluss 7
10 Kontaktstifte der Steckplätze 5
11 mechanische Rastmittel der Steckplätze 5
12 elektrische Leitungen zu der Steckleiste 4
13 elektrischer Anschluss des Magnetventils 2 bzw. Sensors 3
14 Spitze des elektrischen Anschluss 13
15 Schnapphaken des Steckplatzes 5
16 Vorsprünge am Schnapphaken 15
17 Flanken
18 Führungshilfen am Steckplatz 5
19 Kanal für die elektrischen Leitungen

## Patentansprüche

1. Elektrische Schnittstelle für wasserführende Haushaltsgeräte mit einer Programmsteuerung und mit elektronischen Komponenten (6) zur Ansteuerung mindestens eines Magnetventils (2) zur Regelung einer Flüssigkeitsleitung, bei der zumindest ein Teil der elektronischen Komponenten (6) und das Magnetventil (2) in einer Bauteilgruppe (1) integriert sind, die mit der Programmsteuerung verbunden ist, **dadurch gekennzeichnet, dass** die elektrische Schnittstelle eine Steckplatine (1) aufweist, die mit einem elektrischen Anschluss (7) in einen dafür vorgesehenen komplementär ausgebildeten Steckplatz in der Haushaltsmaschine eingesteckt werden kann und die Magnetventile (2) und die elektronischen Komponenten (6) der elektrischen Schnittstelle auf der Platine (1) angeordnet sind.

2. Elektrische Schnittstelle gemäß Anspruch 1, wobei auf der Platine (1) mindestens ein Sensor (3) zur Erfassung von für die Regelung der Flüssigkeitsleitung relevanten, insbesondere hydraulischen Parametern angeordnet ist.

3. Elektrische Schnittstelle gemäß Anspruch 1 oder 2, wobei die Flüssigkeitsleitung die Frischwasserzufuhr einer wasserführenden Haushaltsmaschine oder ein Spülflüssigkeitskreislauf einer Waschmaschine oder ein Waschflüssigkeitskreislauf einer Geschirrspülmaschine ist.

4. Elektrische Schnittstelle gemäß einer der vorangehenden Ansprüche, wobei in der Bauteilgruppe (1) eine Anzahl von Magnetventilen (2) zur Regelung mehrerer Flüssigkeitsleitungen integriert ist.

5. Elektrische Schnittstelle gemäß einer der vorangehenden Ansprüche, wobei die elektronischen Komponenten mindestens einen Mikroprozessor (8) umfassen.

6. Elektrische Schnittstelle gemäß einer der vorangehenden Ansprüche, wobei mindestens ein elektrischer Anschluss (7) für die elektrische Verbindung der Bauteilgruppe (1) zur Programmsteuerung des wasserführenden Haushaltsgeräts vorgesehen ist, der vorzugsweise als Gruppenstecker mit einer Anzahl von elektrischen Kontakten (9) ausgebildet ist.

7. Elektrische Schnittstelle gemäß einem der vorhergehenden Ansprüche, wobei ein Abschnitt am Rand der Platine (1) als elektrischer Anschluss (7) mit einer Anzahl von elektrischen Kontakten (9) ausgebildet ist.

8. Elektrische Schnittstelle gemäß einem der Ansprüche 2 bis 7, wobei die Magnetventile (2) und/oder die Sensoren (3) auf einer oder mehreren Steckleisten (4) angeordnet sind, die mit der Platine (1) über elektrische Leitungen (12) verbunden sind.

9. Elektrische Schnittstelle gemäß einem der Ansprüche 2 bis 8, wobei die Steckleiste (4) für die Magnetventile (2) und/oder die Sensoren (3) eine Anzahl von Steckplätzen (5) aufweist, die zur elektrischen Kontaktierung der Magnetventile (2) und/oder der Sensoren (3) dienen.

10. Elektrische Schnittstelle gemäß Anspruch 10, wobei die Steckplätze (5) Mittel (15, 17) zur mechanischen Verrastung der Magnetventile (2) und/oder der Sensoren (3) bzw. für deren elektrische Anschlüsse (13) aufweisen.

## Claims

1. Electrical interface for water-bearing household appliances having a program control and having electronic components (6) for actuating at least one magnetic valve (2) for controlling a fluid line, in which at least some of the electronic components (6) and the magnetic valve (2) are integrated into a component group (1) which is connected to the program control, **characterised in that** the electrical interface has a breadboard (1) which can be plugged with an electrical connector (7) into a plug-in slot in the household machine which is designed to be complementary and is provided for this purpose, and the magnetic valves (2) and the electronic components (6) of the electrical interface are arranged on the board (1).

2. Electrical interface according to claim 1, wherein at least one sensor (3) for detecting parameters, in particular hydraulic parameters, that are of relevance for controlling the fluid line is arranged on the board (1).

3. Electrical interface according to claim 1 or 2, wherein the fluid line is the fresh water supply of a water-bearing household machine or a rinsing liquid circuit of a washing machine or a washing liquid circuit of a dishwasher.

4. Electrical interface according to one of the preceding claims, wherein a plurality of magnetic valves (2) for controlling multiple fluid lines are integrated into the component group (1).

5. Electrical interface according to one of the preceding claims, wherein the electronic components include at least one microprocessor (8).

6. Electrical interface according to one of the preceding claims, wherein at least one electrical connector (7) is provided for the electrical connection of the component group (1) for program control of the water-bearing household appliance and is preferably designed as a group connector having a plurality of electrical contacts (9).

7. Electrical interface according to one of the preceding claims, wherein a section at the edge of the board (1) is designed as an electrical connection (7) with a plurality of electrical contacts (9).

8. Electrical interface according to one of claims 2 to 7, wherein the magnetic valves (2) and/or the sensors (3) are arranged on one or more connector strips (4) which are connected to the board (1) via electrical leads (12).

9. Electrical interface according to one of claims 2 to 8, wherein the connector strip (4) for the magnetic valves (2) and/or the sensors (3) has a plurality of slots (5) which serve for the electrical contacting of the magnetic valves (2) and/or the sensors (3).

10. Electrical interface according to claim 10, wherein the slots (5) have means (15, 17) for mechanical locking of the magnetic valves (2) and/or of the sensors (3) or for the electrical connections (13) thereof.

## Revendications

1. Interface électrique pour appareils ménagers à circulation d'eau équipés d'une commande à programme et de composants électroniques (6) destinés à commander au moins une électrovanne (2) pour la régulation d'une conduite de liquide, où au moins une partie des composants électroniques (6) et l'électrovanne (2) sont intégrées dans un groupe de composants (1), lequel est interconnecté avec la commande à programme, **caractérisée en ce que** l'interface électrique comprend une platine enfichable (1) qui s'enfiche par une connexion électrique (7) dans un emplacement de forme complémentaire prévu à cet effet dans l'appareil ménager et **en ce que** les électrovannes (2) et les composants électroniques (6) de l'interface électrique sont disposés sur la platine (1).

2. Interface électrique selon la revendication 1, où au moins un capteur (3) pour la détection de paramètres notamment hydrauliques, pertinents pour la régulation de la conduite de liquide, est disposé sur la platine (1).

3. Interface électrique selon la revendication 1 ou 2, où la conduite de liquide est l'alimentation en eau fraîche d'un appareil ménager à circulation d'eau ou un circuit de liquide de rinçage d'un lave-linge ou un circuit de liquide de lavage d'un lave-vaisselle.

4. Interface électrique selon l'une des revendications précédentes, où un certain nombre d'électrovannes (2) pour la régulation de plusieurs conduites de liquide est intégré dans le groupe de composants (1).

5. Interface électrique selon l'une des revendications précédentes, où les composants électroniques comprennent au moins un microprocesseur (8).

6. Interface électrique selon l'une des revendications précédentes, où au moins une connexion électrique (7) pour la liaison électrique du groupe de composants (1) vers la commande par programme de l'appareil ménager à circulation d'eau est prévue, laquelle est réalisée de préférence sous forme de connexion groupée dotée d'un certain nombre de contacts électriques (9).

7. Interface électrique selon l'une des revendications précédentes, où une partie sur le bord de la platine (1) est réalisée sous forme de connexion électrique (7) dotée d'un certain nombre de contacts électriques (9).

8. Interface électrique selon l'une des revendications 2 à 7, où les électrovannes (2) et/ou les capteurs (3) sont disposés sur un ou plusieurs borniers (4), reliés à la platine (1) par des conducteurs électriques (12).

9. Interface électrique selon l'une des revendications 2 à 8, où le bornier (4) pour les électrovannes (2) et/ou les capteurs (3) présente un certain nombre d'emplacements (5), destinés à la mise en contact électrique des électrovannes (2) et/ou des capteurs (3).

10. Interface électrique selon la revendication 10, où les emplacements (5) comportent des moyens (15, 17) permettant l'enclenchement mécanique des électrovannes (2) et/ou des capteurs (3) ou de leurs connexions électriques (13).
